# EUROPEAN PATENT APPLICATION

(11) **EP 2 587 526 A1**
(43) Date of publication of application: **01.05.2013**
(21) Application number: 11798149.8
(22) Date of filing: 21.06.2011
(51) Int. Cl.: H01L 21/304, B24B 37/00

(54) **COMPOSITION FOR POLISHING SILICON CARBIDE SUBSTRATE AND METHOD FOR POLISHING SILICON CARBIDE SUBSTRATE**

(30) Priority: 23.06.2010 JP 2010143158
(71) Applicant: Nissan Chemical Industries, Ltd., Chiyoda-ku Tokyo 101-0054 (JP)
(72) Inventor: SEKIGUCHI, Kazutoshi, Sodegaura-shi Chiba 299-0266 (JP); NISHIMURA, Tooru, Sodegaura-shi Chiba 299-0266 (JP)
(74) Representative: HOFFMANN EITLE
(86) International application number: PCT/JP2011/064179
(87) International publication number: WO 2011/162265

(57) **Abstract**

The invention provides a silicon carbide substrate polishing composition for polishing a surface of a silicon carbide substrate, characterized in that the composition contains water and colloidal silica particles having a true specific gravity of 2.10 to 2.30, and has a free alkali metal ion concentration of 1 ppm to 150 ppm.

## Description

### Technical Field

The present invention relates to a composition for polishing a silicon carbide substrate and to a method for polishing a silicon carbide substrate.

### Background Art

Substrates of electronic devices are known to be generally employed silicon substrates and silicon carbide substrates such as a 4H-SiC single-crystal substrate and a 6H-SiC single-crystal substrate. The silicon carbide substrates are useful materials by virtue of properties such as high mechanical strength.

Such a silicon carbide substrate is produced through growing a silicon carbide crystal and cutting the produced single-crystal ingot to pieces having a shape of interest. Since the surface of the silicon carbide substrate is desired to have flatness, the surface is generally polished by use of diamond. In the polishing process by use of diamond, the substrate is provided with micro-roughness. Thus, the surface is further polished by use of an abrasive other than diamond for finishing. Such an abrasive is, for example, a polishing composition containing water, silica particles having a specific particle size, and an oxidizing agent. In chemical mechanical polishing (CMP), which is a known polishing technique, the surface of a silicon carbide substrate is treated with such a polishing composition (see, for example, Patent Document 1).

### Prior Art Documents

### Patent Documents

Patent Document 1: Japanese Patent Application Laid-Open *(kokai)* No. 2010-503232

### Summary of the Invention

### Problems to be Solved by the Invention

However, when the aforementioned technique is employed, surface planarization is insufficiently attained. Thus, in a trend for downscaling of electronic devices, there is demand for a silicon carbide substrate having a higher degree of surface flatness.

An object of the present invention to solve the aforementioned problem is to provide a composition and a method for polishing a silicon carbide substrate which can provide a silicon carbide substrate having a high degree of surface flatness.

### Means for Solving the Problems

Accordingly, the composition for polishing a silicon carbide substrate of the present invention for solving the aforementioned problem is a silicon carbide substrate polishing composition for polishing a surface of a silicon carbide substrate, characterized in that the composition comprises water and colloidal silica particles having a true specific gravity of 2.10 to 2.30, and has a free alkali metal ion concentration of 1 ppm to 150 ppm.

Preferably, the colloidal silica particles contain colloidal silica particles having a mean primary particle size of 20 nm to 500 nm.

More preferably, the colloidal silica particles further contain colloidal silica particles having a mean primary particle size of 5 nm or more and less than 20 nm. The silicon carbide substrate polishing composition preferably has a ratio by mass of colloidal silica particles having a mean primary particle size of 20 nm to 500 nm to colloidal silica particles having a mean primary particle size of 5 nm or more and less than 20 nm of 50/50 to 90/10.

The silicon carbide substrate polishing composition preferably has a pH lower than 4.
The silicon carbide substrate polishing composition preferably further contains an oxidizing agent.
The composition for polishing a silicon carbide substrate may be employed with an oxidizing agent in polishing a silicon carbide substrate.

The oxidizing agent is preferably at least one species selected from the group consisting of hydrogen peroxide, chloric acid, perchloric acid, perbromic acid, iodic acid, periodic acid, persulfuric acid, perboric acid, permanganic acid, chromic acid, dichromic acid, vanadic acid, chlorinated cyanuric acid, and ammonium salts thereof.

In another mode of the present invention, there is provided a method for polishing a silicon carbide substrate, characterized in that the method comprises polishing a surface of the silicon carbide substrate by use of the aforementioned composition for polishing a silicon carbide substrate.

### Effects of the Invention

The present invention enables provision of a silicon carbide substrate polishing composition which can provide a silicon carbide substrate having a flat surface. Through polishing a surface of a silicon carbide substrate by use of the silicon carbide substrate polishing composition, a silicon carbide substrate having a flat surface can be produced.

### Brief Description of the Drawings

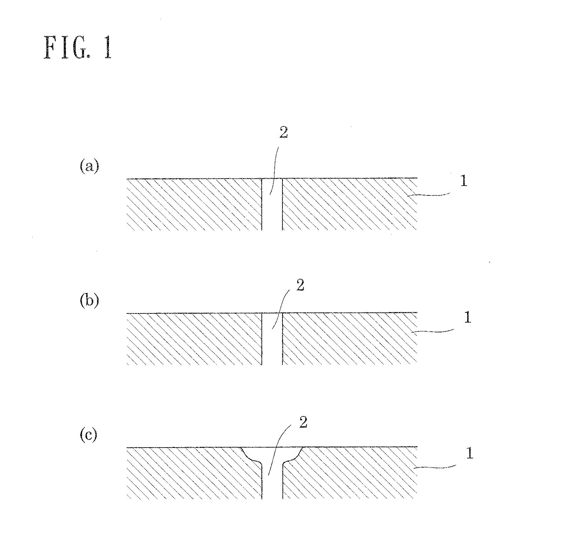

[Fig. 1] Cross-sections of a silicon carbide substrate.

### Modes for Carrying Out the Invention

The silicon carbide substrate polishing composition of the present invention for polishing a surface of a silicon carbide substrate comprises water and colloidal silica particles having a true specific gravity of 2.10 to 2.30, and has a free alkali metal ion concentration of 1 ppm to 150 ppm.

No particular limitation is imposed on the type of the silicon carbide substrate to be polished by the composition for polishing a silicon carbide substrate of the present invention. Examples of the silicon carbide substrate include a hexagonal 4H-SiC single-crystal substrate and a 6H-SiC single-crystal substrate. The silicon carbide substrate is produced through a conventional production method; e.g., crystal growth by a modified Lely method and cutting the produced single-crystal ingot.

The colloidal silica particles used in the present invention have a true specific gravity of 2.10 to 2.30. The colloidal silica particles having a true specific gravity of 2.10 to 2.30 are hard particles and are equivalent to colloidal silica particles produced through the so-called water glass method, which are different from silica particles having a small true specific gravity (e.g., about 1.70 to about 2.00) and produced through the sol-gel method (i.e., a methyl silicate method). Through employment of hard colloidal silica particles having a true specific gravity of 2.10 to 2.30 in combination with an oxidizing agent, the surface of the silicon carbide substrate having a hardness of 9 or higher, which surface has a roughness provided by diamond or other abrasives, can be satisfactorily polished. As used herein, the water glass method refers to a method for producing colloidal silica, the method including diluting an aqueous solution of an alkali metal silicate (e.g., sodium silicate) to a concentration of interest; removing cations from the solution, to thereby produce an active silicic acid solution; and heating the silicic acid in an alkaline solution, to thereby grow colloidal silica particles, or neutralizing an aqueous solution of an alkali metal silicate with a mineral acid, to thereby form silica gel; and deflocculating the silica gel with alkali. The sol-gel method refers to a method for producing silica particles including reacting an alkoxysilane with water in an alcoholic solution in the presence of a basic catalyst.

No particular limitation is imposed on the particle size of the colloidal silica particles. However, the polishing composition of the invention preferably contains colloidal silica particles having a mean primary particle size of 20 nm to 500 nm as a predominant component; for example, in an amount of 50 mass% or more with respect to all colloidal silica particles. The mean primary particle size may be determined through the nitrogen adsorption method. When only colloidal silica particles having a mean primary particle size smaller than 20 nm are used, edges of the pores formed in the surface portion of the silicon carbide substrate (e.g., micropipes (i.e., capillary defects) and dislocations) are ground, whereby the openings of the pores tend to be enlarged, and the depths thereof tend to increase. In this case, when the pores are observed under an atomic force microscope, the probe can readily enter the pores. The colloidal silica particles having a mean primary particle size larger than 500 nm tend to gradually undergo spontaneous sedimentation when allowed to stand, to thereby cause layer separation, making handing of the particles difficult. The colloidal silica particles used in the invention may be a mixture of two or more species of colloidal silica particles having different mean primary particle sizes.

Furthermore, the colloidal silica particles preferably further contain colloidal silica particles having a mean primary particle size of 5 nm or more and less than 20 nm, in addition to colloidal silica particles having a mean primary particle size of 20 nm to 500 nm. By use of a silicon carbide substrate polishing composition containing colloidal silica particles which include those having a mean primary particle size of 20 nm to 500 nm in combination with those having a mean primary particle size 5 nm or more and less than 20 nm, a silicon carbide substrate having a flat surface can be produced, and the polishing time can be shortened by virtue of an increased polishing speed. No particular limitation is imposed on the composition (ratio) of the colloidal silica particles. The ratio by mass of colloidal silica particles having a mean primary particle size of 20 nm to 500 nm to colloidal silica particles having a mean primary particle size of 5 nm or more and less than 20 nm (i.e., (colloidal silica particles having a mean primary particle size of 20 nm to 500 nm)/colloidal silica particles having a mean primary particle size of 5 nm or more and less than 20 nm)) is preferably 50/50 to 90/10.

The composition for polishing a silicon carbide substrate of the present invention has a free alkali metal ion concentration of 1 ppm to 150 ppm, preferably 1 ppm to 100 ppm. When the free alkali metal ion concentration is higher than 150 ppm, which falls outside the scope of the invention, a silicon carbide substrate having a flat surface fails to be produced.

During production of silicon carbide substrates, pores are unavoidably provided in the surface portion of a substrate in the course of crystal growth. Such pores include pipe-shape pores having a diameter (as viewed from the surface of the substrate) of about 1 to about 10 µm (i.e., micropipes) and dislocations (crystal defects) having a diameter of about 0.5 to about 10 µm generated from irregular arrangement in the crystal structure. Thus, a silicon carbide substrate having in a surface portion thereof pores such as micropipes and dislocations is polished with an abrasive composition containing silica particles or a similar material for removing roughness given by polishing with diamond or a similar process.

One finding of the present inventors is as follows. When polishing is performed by use of a conventional abrasive composition, the openings of the pores (e.g., micropipes and dislocations) present in the surface portion of the silicon carbide substrate are enlarged, and the depths thereof tend to increase. When the pores are observed under an atomic force microscope, the probe can readily enter the pores. Another finding is as follows. Enlargement of the opening of the pores during polishing with an abrasive composition is caused by a high free alkali metal ion concentration of the abrasive composition.

A more specific feature will be described with reference to Fig. 1, which is a cross-section of a silicon carbide substrate having micropipes. When a silicon carbide substrate 1 having a micropipe 2 (Fig. 1(a)) is polished with the silicon carbide substrate polishing composition of the present invention, having a free alkali metal ion concentration of 150 ppm or less, the opening of the micropipe 2 is not enlarged (Fig. 1(b)). In contrast, when polishing is performed with a conventional abrasive composition, having high free alkali metal ion concentration, the opening of the micropipe 2 is enlarged through polishing (Fig. 1(c)). In this case, the polished surface of the silicon carbide substrate has a greater roughness, as compared with the polishing case where the silicon carbide substrate polishing composition of the present invention is used.

In an abrasive composition containing colloidal silica particles produced through the water glass method (e.g., an abrasive Nalco 1034 (product of Nalco) disclosed in the Examples of Patent Document 1), the colloidal silica particles contain alkali metals intermingled thereinto during production thereof. Therefore, unless the free alkali metal ion level is reduced to 150 ppm or less, the abrasive composition intrinsically has a free alkali metal ion concentration in excess of 150 ppm. When the surface of a silicon carbide substrate is polished with a conventional abrasive composition, having a free alkali metal ion concentration in excess of 150 ppm, a silicon carbide substrate having a flat surface fails to be produced, and also, the openings of the pores are enlarged.

Meanwhile, when an abrasive composition containing silica particles produced through the sol-gel method (e.g., Fuso PL-1 (product of Fuso Chemical Co., Ltd.) disclosed in Patent Document 1) is employed, as described above, difficulty is encountered in polishing the hard surface of a silicon carbide substrate due to poor hardness of silica particles. Therefore, roughness given by polishing with diamond or a similar treatment cannot be removed, and the performance of the silicon carbide substrate polishing composition of the present invention cannot be obtained.

No particular limitation is imposed on the pH of the silicon carbide substrate polishing composition of the present invention, but the pH is preferably lower than 4, more preferably higher than 2 and lower than 4. When the pH is 2 or lower, a polishing machine employing the composition tends to be corroded, whereas when the pH is 4 or higher, the dispersion stability of colloidal silica particles tends to decrease.

The silicon carbide substrate polishing composition of the present invention may contain an oxidizing agent. When the composition contain no oxidizing agent, the composition may be used in combination with an oxidizing agent in polishing a silicon carbide substrate. Needless to say, when the silicon carbide substrate polishing composition of the present invention contains an oxidizing agent, the composition may also be employed with an additional oxidizing agent in polishing a silicon carbide substrate. One conceivable reason why use of the oxidizing agent provides a silicon carbide substrate having a higher degree of flatness is that the surface of the silicon carbide substrate is oxidized to form silicon oxide, which is polished by colloidal silica particles.

Non particular limitation is imposed on the oxidizing agent, and examples of the oxidizing agent include hydrogen peroxide, chloric acid, perchloric acid, perbromic acid, iodic acid, periodic acid, persulfuric acid, perboric acid, permanganic acid, chromic acid, dichromic acid, vanadic acid, chlorinated cyanuric acid, and ammonium salts thereof. Needless to say, these oxidizing agents may be used in combination of two or more species.

The silicon carbide substrate polishing composition of the present invention may further contain known additives such as a pH-controlling agent, a pH buffer, a surfactant, a dispersion stabilizer, a gelation-preventing agent, a defoaming agent, a chelating agent, and a bactericide.

Meanwhile, since the silicon carbide substrate polishing composition of the present invention has an alkali metal ion concentration of 150 ppm or less, the oxidizing agent and other additives incorporated into the composition must have a free alkali metal ion concentration lower than the above level.

No particular limitation is imposed on the amount of each component contained in the silicon carbide substrate polishing composition of the present invention. For example, the silicon carbide substrate polishing composition preferably has a colloidal silica particle content of about 1 to about 50 mass% and an oxidizing agent content of about 0.1 to about 5 mass%.

No particular limitation is imposed on the method of producing the silicon carbide substrate polishing composition. In one production procedure, colloidal silica particles having a true specific gravity of 2.10 to 2.30 (i.e., colloidal silica particles produced through the water glass method) are treated with a strongly acidic hydrogen-type cation-exchange resin or subjected to a similar treatment, to thereby reduce the free alkali metal ion level, and the colloidal silica particles having a reduced free alkali metal ion level are mixed with water. When a silicon carbide substrate polishing composition containing an oxidizing agent is produced, an oxidizing agent is incorporated into the composition. Notably, in the above case, the free alkali metal ion level of the colloidal silica particles is reduced before mixing with water or the like. However, alternatively, the free alkali metal ion level of the colloidal silica particles produced through the water glass method may be reduced after mixing with water or the like. As described above, the colloidal silica particles contained in the silicon carbide substrate polishing composition of the present invention have a true specific gravity of 2.10 to 2.30; i.e., have been produced through the water glass method, alkali metals are intermingled to the colloidal silica particles during production thereof. Thus, free alkali metal ions must be removed from the particles before or after mixing of the colloidal silica particles with water or the like.

Through polishing the surface of a silicon carbide substrate with the silicon carbide substrate polishing composition of the present invention, problematic broadening of openings of intrinsic pores (e.g., micropipes and dislocations), which would otherwise occur in polishing by use of a conventional abrasive composition, can be prevented. Thus, a silicon carbide substrate having a considerably high degree of flatness can be produced. In addition, since the silicon carbide substrate polishing composition of the present invention contains colloidal silica particles obtained through the water glass method, surface roughness provided by polishing with diamond or the like can be sufficiently removed.

No particular limitation is imposed on the polishing method employing the silicon carbide substrate polishing composition of the present invention, and the surface of a silicon carbide substrate may be polished through a technique similar to a technique employing a conventional abrasive composition. In one polishing procedure, the silicon carbide substrate polishing composition is applied to a silicon carbide substrate to be polished, and the work is polished with the composition by means of a polishing pad or the like. Examples

The present invention will next be described in more detail by way of examples, which should not be construed as limiting the invention thereto.

### Example 1

An alkaline silica sol in which colloidal silica particles (mean primary particle size determined through the nitrogen adsorption method: 22 nm, a true specific gravity: 2.18) produced through the water glass method were dispersed was treated with a strongly acidic hydrogen-type cation-exchange resin Amberlite (registered trademark) IR-120B (product of Organo Corporation), to thereby remove alkali metal ions from the sol. The acidic silica sol (colloidal silica particle content: 40 mass%) (9,000 g) produced through removal of alkali metal ions was mixed with pure water (2,660 g) and 35-mass% aqueous hydrogen peroxide (340 g), to thereby prepare 12,000 g of a silicon carbide substrate polishing composition. The thus-produced silicon carbide substrate polishing composition was found to have a colloidal silica particle content 30 mass%, a pH of 2.4, and a free alkali metal ion concentration of 100 ppm. Next, the true specific gravity of colloidal silica particles, the mean primary particle size of colloidal silica particles, and the free alkali metal ion concentration were determined through the following methods.

### <Determination of true specific gravity of colloidal silica particles>

The silicon carbide substrate polishing composition was dried at 100°C for 12 hours and at 150°C for one hour. An aliquot (1 g) was sampled from the dried composition, and the density of the sample was measured by means of a dry auto-densimeter (Acupic 1330, product of Shimadzu Corporation).

### <Determination of mean primary particle size of colloidal silica particles>

A dispersion of colloidal silica particles in water was dried, and the specific surface area of the thus-prepared particles was determined through the BET method by means of MONOSORB (product of Sysmex Corporation). The sphere-equivalent particle size was calculated from the specific surface area.

### <Determination of free alkali metal ion concentration>

The silicon carbide substrate polishing composition was diluted with pure water so as to adjust the colloidal silica particle content to 3 mass%. An aliquot (9 g) of the diluted composition was weighed and placed in a centrifugal ultrafiltration apparatus (cutoff molecular weight: 10,000) (Centricut U-10, product of Kurabo Industries Ltd.) and treated by means of a centrifuge (SRX-201, product of Tomy Seiko Co., Ltd.) at 440 G for 30 minutes. The thus-recovered filtrate was appropriately diluted, and the diluted sample was assayed by means of an ICP emission spectrometer (SPS-7800, product of SII Nanotechnology Inc.).

### Example 2

The procedure of Example 1 was repeated, except that an alkaline silica sol (9,000 g) in which colloidal silica particles (mean primary particle size determined through the nitrogen adsorption method: 35 nm, a true specific gravity: 2.19) produced through the water glass method were dispersed was used instead of the alkaline silica sol in which colloidal silica particles (mean primary particle size determined through the nitrogen adsorption method: 22 nm, a true specific gravity: 2.18) produced through the water glass method were dispersed. The thus-produced silicon carbide substrate polishing composition was found to have a colloidal silica particle content of 30 mass%, a pH of 2.0, and a free alkali metal ion concentration of 53 ppm.

### Example 3

The procedure of Example 1 was repeated, except that an alkaline silica sol (9,000 g) in which colloidal silica particles (mean primary particle size determined through the nitrogen adsorption method: 45 nm, a true specific gravity: 2.21) produced through the water glass method were dispersed was used instead of the alkaline silica sol in which colloidal silica particles (mean primary particle size determined through the nitrogen adsorption method: 22 nm, a true specific gravity: 2.18) produced through the water glass method were dispersed. The thus-produced silicon carbide substrate polishing composition was found to have a colloidal silica particle content of 30 mass%, a pH of 2.4, and a free alkali metal ion concentration of 17 ppm.

### Example 4

An alkaline silica sol in which colloidal silica particles (mean primary particle size determined through the nitrogen adsorption method: 85 nm, a true specific gravity: 2.19) produced through the water glass method were dispersed was treated with a strongly acidic hydrogen-type cation-exchange resin Amberlite IR-120B (product of Organo Corporation), to thereby remove alkali metal ions from the sol. The acidic silica sol (colloidal silica particle content: 35 mass%) (6,857 g) produced through removal of alkali metal ions was mixed with pure water (4,802 g) and 35-mass% aqueous hydrogen peroxide (340 g), to thereby prepare 12,000 g of a silicon carbide substrate polishing composition. The thus-produced silicon carbide substrate polishing composition was found to have a colloidal silica particle content 20 mass%, a pH of 1.9, and a free alkali metal ion concentration of 81 ppm. The true specific gravity of colloidal silica particles, the mean primary particle size of colloidal silica particles, and the free alkali metal ion concentration were determined through the same method as employed in Example 1.

### Example 5

An alkaline silica sol in which colloidal silica particles (mean primary particle size determined through the nitrogen adsorption method: 160 nm, a true specific gravity: 2.20) produced through the water glass method were dispersed was treated with a strongly acidic hydrogen-type cation-exchange resin Amberlite IR-120B (product of Organo Corporation), to thereby remove alkali metal ions from the sol. The acidic silica sol (colloidal silica particle content: 40 mass%) (11,660 g) produced through removal of alkali metal ions was mixed with 35-mass% aqueous hydrogen peroxide (340 g), to thereby prepare 12,000 g of a silicon carbide substrate polishing composition. The thus-produced silicon carbide substrate polishing composition was found to have a colloidal silica particle content 39 mass%, a pH of 1.9, and a free alkali metal ion concentration of 100 ppm. The true specific gravity of colloidal silica particles, the mean primary particle size of colloidal silica particles, and the free alkali metal ion concentration were determined through the same method as employed in Example 1.

### Example 6

The procedure of Example 5 was repeated, except that an alkaline silica sol in which colloidal silica particles (mean primary particle size determined through the nitrogen adsorption method: 310 nm, a true specific gravity: 2.21) produced through the water glass method were dispersed was used instead of the alkaline silica sol in which colloidal silica particles (mean primary particle size determined through the nitrogen adsorption method: 160 nm, a true specific gravity: 2.20) produced through the water glass method were dispersed. The thus-produced silicon carbide substrate polishing composition was found to have a colloidal silica particle content of 39 mass%, a pH of 3.2, and a free alkali metal ion concentration of 14 ppm.

### Example 7

An alkaline silica sol (5,485 g) in which colloidal silica particles (mean primary particle size determined through the nitrogen adsorption method: 85 nm, a true specific gravity: 2.20) produced through the water glass method were dispersed, and an alkaline silica sol (1,200 g) in which colloidal silica particles (mean primary particle size determined through the nitrogen adsorption method: 22 nm, a true specific gravity: 2.18) produced through the water glass method were dispersed were mixed together. The thus-prepared alkaline silica sol mixture was treated with a strongly acidic hydrogen-type cation-exchange resin Amberlite IR-120B (product of Organo Corporation), to thereby remove alkali metal ions from the sol. The acidic silica sol (colloidal silica particle content: 36 mass%) produced through removal of alkali metal ions was mixed with pure water (4,975 g) and 35-mass% aqueous hydrogen peroxide (340 g), to thereby prepare 12,000 g of a silicon carbide substrate polishing composition. The thus-produced silicon carbide substrate polishing composition was found to have a colloidal silica particle content of 20 mass%, a pH of 2.1, a free alkali metal ion concentration of 78 ppm, a true specific gravity of 2.19, and a ratio by mass of colloidal silica particles having a mean primary particle size of 85 nm to colloidal silica particles having a mean primary particle size of 22 nm of 80/20. The true specific gravity of colloidal silica particles, the mean primary particle size of colloidal silica particles, and the free alkali metal ion concentration were determined through the same method as employed in Example 1.

### Example 8

An alkaline silica sol (5,400 g) in which colloidal silica particles (mean primary particle size determined through the nitrogen adsorption method: 35 nm, a true specific gravity: 2.19) produced through the water glass method were dispersed, and an alkaline silica sol (960 g) in which colloidal silica particles (mean primary particle size determined through the nitrogen adsorption method: 12 nm, a true specific gravity: 2.18) produced through the water glass method were dispersed were mixed together. The thus-prepared alkaline silica sol mixture was treated with a strongly acidic hydrogen-type cation-exchange resin Amberlite IR-120B (product of Organo Corporation), to thereby remove alkali metal ions from the sol. The acidic silica sol (colloidal silica particle content: 38 mass%) produced through removal of alkali metal ions was mixed with pure water (5,300 g) and 35-mass% aqueous hydrogen peroxide (340 g), to thereby prepare 12,000 g of a silicon carbide substrate polishing composition. The thus-produced silicon carbide substrate polishing composition was found to have a colloidal silica particle content of 20 mass%, a pH of 2.2, a free alkali metal ion concentration of 37 ppm, a true specific gravity of 2.19, and a ratio by mass of colloidal silica particles having a mean primary particle size of 35 nm to colloidal silica particles having a mean primary particle size of 12 nm of 90/10. The true specific gravity of colloidal silica particles, the mean primary particle size of colloidal silica particles, and the free alkali metal ion concentration were determined through the same method as employed in Example 1.

### Comparative Example 1

An alkaline silica sol (colloidal silica particle content: 40 mass%) (6,000 g) in which colloidal silica particles (mean primary particle size determined through the nitrogen adsorption method: 12 nm, a true specific gravity: 2.18) produced through the water glass method were dispersed, pure water (5,660 g), and 35-mass% aqueous hydrogen peroxide (340 g) were mixed together, to thereby prepare 12,000 g of a silicon carbide substrate polishing composition. The thus-produced silicon carbide substrate polishing composition was found to have a colloidal silica particle content of 20 mass%, a pH of 10.3, and a free alkali metal ion concentration of 1,700 ppm. The true specific gravity of colloidal silica particles, the mean primary particle size of colloidal silica particles, and the free alkali metal ion concentration were determined through the same method as employed in Example 1.

### Comparative Example 2

The procedure of Comparative Example 1 was repeated, except that an alkaline silica sol (6,000 g) in which colloidal silica particles (mean primary particle size determined through the nitrogen adsorption method: 35 nm, a true specific gravity: 2.18) produced through the water glass method were dispersed, instead of an alkaline silica sol in which colloidal silica particles (mean primary particle size determined through the nitrogen adsorption method: 12 nm, a true specific gravity: 2.18) produced through the water glass method were dispersed. The thus-produced silicon carbide substrate polishing composition was found to have a colloidal silica particle content of 20 mass%, a pH of 9.5, and a free alkali metal ion concentration of 450 ppm. The true specific gravity of colloidal silica particles, the mean primary particle size of colloidal silica particles, and the free alkali metal ion concentration were determined through the same method as employed in Example 1.

### Comparative Example 3

The procedure of Comparative Example 1 was repeated, except that an alkaline silica sol (6,000 g) in which colloidal silica particles (mean primary particle size determined through the nitrogen adsorption method: 85 nm, a true specific gravity: 2.19) produced through the water glass method were dispersed, instead of an alkaline silica sol in which colloidal silica particles (mean primary particle size determined through the nitrogen adsorption method: 12 nm, a true specific gravity: 2.18) produced through the water glass method were dispersed. The thus-produced silicon carbide substrate polishing composition was found to have a colloidal silica particle content of 20 mass%, a pH of 9.5, and a free alkali metal ion concentration of 320 ppm. The true specific gravity of colloidal silica particles, the mean primary particle size of colloidal silica particles, and the free alkali metal ion concentration were determined through the same method as employed in Example 1.

### Comparative Example 4

An alkaline silica sol (colloidal silica particle content: 40 mass%) (9,000 g) in which colloidal silica particles (mean primary particle size determined through the nitrogen adsorption method: 40 nm, a true specific gravity: 2.16) produced through the water glass method were dispersed, pure water (2,660 g), and 35-mass% aqueous hydrogen peroxide (340 g) were mixed together, to thereby prepare 12,000 g of a silicon carbide substrate polishing composition. The thus-produced silicon carbide substrate polishing composition was found to have a colloidal silica particle content of 30 mass%, a pH of 10.0, and a free alkali metal ion concentration of 1,000 ppm. The true specific gravity of colloidal silica particles, the mean primary particle size of colloidal silica particles, and the free alkali metal ion concentration were determined through the same method as employed in Example 1.

### Comparative Example 5

A neutral silica sol (colloidal silica particle content: 35 mass%) (10,286 g) in which colloidal silica particles (mean primary particle size determined through the nitrogen adsorption method: 35 nm, a true specific gravity: 2.00) produced through the methyl silicate method were dispersed, pure water (1,250 g), 10-mass% sulfuric acid (124 g), and 35-mass% aqueous hydrogen peroxide (340 g) were mixed together, to thereby prepare 12,000 g of a silicon carbide substrate polishing composition. The thus-produced silicon carbide substrate polishing composition was found to have a colloidal silica particle content of 30 mass%, a pH of 2.1, and a free alkali metal ion concentration lower than 1 ppm. The true specific gravity of colloidal silica particles, the mean primary particle size of colloidal silica particles, and the free alkali metal ion concentration were determined through the same method as employed in Example 1.

### Test Example

By use of each of the silicon carbide substrate polishing compositions produced in Examples 1 to 8 and Comparative Examples 1 to 5, a silicon carbide substrate was polished under the following polishing conditions. Before and after polishing, the surface of the silicon carbide substrate was observed under an atomic force microscope (AFM: Dimension 3100, product of Veeco Instruments), and the depth of a micropipe formed in the surface portion of the silicon carbide substrate was measured. The measurement was carried out at three times (mean value Rₘₐₓ). Table 1 shows the results. Also, the polished silicon carbide substrate was washed with pure water and dried, and the weight loss of the substrate was measured, whereby the polishing rate was determined. Table 1 shows the results.

### <Polishing conditions>

Polishing work: n-type 4H-SiC single-crystal substrate (diameter: 2 inches, off angle: 4°), (0001) Si face Polishing machine: LAPMASTER LM18S polisher (product of LapmasterSFT Corp.)
Polishing pad: 18-inch-Φ Suba 600 (product of Nitta Haas Inc.)
SiC substrate polishing composition feed rate: 20 mL/min (1 pass)
Surface plate rotation: 60 rpm
Head rotation : 60 rpm
Work pressure: 300 g/cm²
Polishing time: 8 hours

In Examples 1 to 8, in which the free alkali metal ion concentration was 150 ppm or lower, the Rₘₐₓ of micropipes was not changed before and after polishing, and the openings of the micropipes did not increase. In contrast, in Comparative Examples 1 to 4, in which the free alkali metal ion concentration was relatively high, the Rₘₐₓ of micropipes increased after polishing, and the openings of the micropipes increased. That is, the surface areas of the silicon carbide substrate in the vicinity of the micropipes had a surface roughness greater than that measured before polishing. In addition, the silicon carbide substrate polishing composition of the present invention was able to remove surface roughness given by polishing with diamond or a similar material. In Comparative Example 5, although the Rₘₐₓ of micropipes was not changed before and after polishing, and the openings of the micropipes did not increase, the polishing rate was poor, and surface roughness given by polishing with diamond or a similar material was not removed.

**[Table 1]**

| | Colloidal silica particles | | | | | | | | | | pH | Free alkali metal ion concentration (ppm) | | | | Oxidizing agent | | Evaluation | | |
|---|---|---|---|---|---|---|---|---|---|---|---|---|---|---|---|---|---|---|---|---|
| | Content (parts by mass) | Mean primary particle size (nm) | | | | | | | | True d. | | | | | | Type | Amount (wt.%) | Rmax (nm) | | Polishing rate (µm /hr) |
| | | 12 | 22 | 35 | 40 | 45 | 85 | 160 | 310 | | | Li | Na | K | Total | | | Before | After | |
| Ex. 1 | 30 | - | 100% | - | - | - | - | - | - | 2.18 | 2.4 | 0 | 100 | 0 | 100 | H₂O₂ | 1 | 160 | 160 | 0.06 |
| Ex. 2 | 30 | - | - | 100% | - | - | - | - | - | 2.19 | 2.0 | 0 | 53 | 0 | 53 | H₂O₂ | 1 | 160 | 160 | 0.18 |
| Ex. 3 | 30 | - | - | - | - | 100% | - | - | - | 2.21 | 2.4 | 0 | 17 | 0 | 17 | H₂O₂ | 1 | 160 | 160 | 0.20 |
| Ex. 4 | 20 | - | | - | - | - | 100% | - | - | 2.19 | 1.9 | 0 | 81 | 0 | 81 | H₂O₂ | 1 | 160 | 160 | 0.23 |
| Ex. 5 | 39 | - | - | - | - | - | - | 100% | - | 2.20 | 1.9 | 0 | 100 | 0 | 100 | H₂O₂ | 1 | 160 | 160 | 0.21 |
| Ex. 6 | 39 | | | | - | - | - | - | 100% | 2.21 | 3.2 | 0 | 14 | 0 | 14 | H₂O₂ | 1 | 160 | 160 | 0.24 |
| Ex. 7 | 20 | - | 20% | - | - | - | 80% | - | - | 2.19 | 2.1 | 0 | 78 | 0 | 78 | H₂O₂ | 1 | 160 | 160 | 0.32 |
| Ex. 8 | 20 | 10% | - | 90% | - | - | - | - | - | 2.19 | 2.2 | 0 | 37 | 0 | 37 | H₂O₂ | 1 | 160 | 160 | 0.29 |
| Comp. Ex. 1 | 20 | 100% | - | - | - | - | - | - | - | 2.18 | 10.3 | 0 | 1,700 | 0 | 1,700 | H₂O₂ | 1 | 160 | 250 | 0.08 |
| Comp. Ex. 2 | 20 | - | - | 100% | - | - | | - | - | 2.18 | 9.5 | 0 | 450 | 0 | 450 | H₂O₂ | 1 | 160 | 210 | 0.22 |
| Comp. Ex. 3 | 20 | - | - | - | - | - | 100% | - | - | 2.19 | 9.5 | 0 | 320 | 0 | 320 | H₂O₂ | 1 | 160 | 380 | 0.26 |
| Comp. Ex. 4 | 30 | - | - | - | 100% | - | - | - | - | 2.16 | 10.0 | 0 | 1,000 | 0 | 1,000 | H₂O₂ | 1 | 160 | 300 | 0.30 |
| Comp. Ex. 5 | 30 | - | - | 100% | - | - | - | - | - | 2.00 | 2.1 | 0 | 0 | 0 | <1 | H₂O₂ | 1 | 160 | 160 | 0.02 |

### Description of Reference Numerals

1 Silicon carbide substrate
2 Micropipe

## Claims

1. A silicon carbide substrate polishing composition for polishing a surface of a silicon carbide substrate, **characterized in that** the composition comprises water and colloidal silica particles having a true specific gravity of 2.10 to 2.30, and has a free alkali metal ion concentration of 1 ppm to 150 ppm.

2. A silicon carbide substrate polishing composition according to claim 1, wherein the colloidal silica particles contain colloidal silica particles having a mean primary particle size of 20 nm to 500 nm.

3. A silicon carbide substrate polishing composition according to claim 2, wherein the colloidal silica particles further contain colloidal silica particles having a mean primary particle size of 5 nm or more and less than 20 nm.

4. A silicon carbide substrate polishing composition according to claim 3, which has a ratio by mass of colloidal silica particles having a mean primary particle size of 20 nm to 500 nm to colloidal silica particles having a mean primary particle size of 5 nm or more and less than 20 nm of 50/50 to 90/10.

5. A silicon carbide substrate polishing composition according to any one of claims 1 to 4, which has a pH lower than 4.

6. A silicon carbide substrate polishing composition according to any one of claims 1 to 5, which further contains an oxidizing agent.

7. A silicon carbide substrate polishing composition according to any one of claims 1 to 5, which is employed with an oxidizing agent in polishing a silicon carbide substrate.

8. A silicon carbide substrate polishing composition according to claim 6 or 7, wherein the oxidizing agent is at least one species selected from the group consisting of hydrogen peroxide, chloric acid, perchloric acid, perbromic acid, iodic acid, periodic acid, persulfuric acid, perboric acid, permanganic acid, chromic acid, dichromic acid, vanadic acid, chlorinated cyanuric acid, and ammonium salts thereof.

9. A method for polishing a silicon carbide substrate, **characterized in that** the method comprises polishing a surface of the silicon carbide substrate by use of a silicon carbide substrate polishing composition as recited in any one of claims 1 to 8.
